# EUROPEAN PATENT SPECIFICATION

(11) **EP 1 889 946 B1**
(45) Date of publication and mention of the grant of the patent: **31.10.2012**
(21) Application number: 07114124.6
(22) Date of filing: 09.08.2007
(51) Int. Cl.: C23C 16/455, C23C 16/452, H01J 37/32

(54) **Surface Processing Apparatus**
Oberflächenbearbeitungsvorrichtung
Appareil de traitement de surface

(30) Priority: 14.08.2006 GB 0616131
(43) Date of publication of application: 20.02.2008
(73) Proprietor: Oxford Instruments Nanotechnology Tools Limited, Oxon OX13 5QX (GB)
(72) Inventor: Thomas, Owain Peredur, Cardiff, CF23 8PP (GB); Griffiths, Andrew John Vassilios, Bristol, BS9 2EA (GB); Cooke, Michael Joseph, Bristol, BS35 1JJ (GB)
(74) Representative: Skone James, Robert Edmund

(56) References cited:
- WO-A-2006/000846
- JP-A- 8 274 083
- US-A- 4 792 378
- US-A1- 2005 092 243
- US-A1- 2006 027 166

## Description

The present invention relates to apparatus for the surface processing of a substrate, in particular apparatus that utilises high-density plasma to aid chemical vapour deposition or etching.

Chemical vapour deposition (CVD) and plasma etching are well-known processing methods used in the semiconductor and integrated circuit industry. In a standard CVD process a semiconductor wafer is placed within a specialised reaction chamber and the surface of the wafer is exposed to various chemical substances, wherein the chemical substances are injected into the reaction chamber in gaseous form or within a carrier gas. The chemical substances typically comprise one or more volatile precursors, which react with and/or decompose upon the wafer substrate to alter the surface of the semiconductor wafer and provide the necessary processing in dependence on the chemistry of the substances involved. In many processes volatile gaseous by-products are also produced, which are removed using a gas flow through the reaction chamber. Surface reactions can either add new material or etch the existing surface. Common processing operations include the deposition of layers of material upon the wafer substrate and the etching of layers of material from the wafer substrate to form device components, electrical connections, dielectrics, charge barriers and other common circuit elements.

In recent times, plasma enhancement has been incorporated into CVD systems in order to enhance the quality and/or processing rate of the surface process. These plasma-enhanced CVD (PECVD) systems generally operate by the dissociation and ionisation of gaseous chemicals to increase the reactivity of the one or more chemical precursors. This enhanced reactivity due to energetic particles in the plasma increases the processing rate and allows lower processing temperatures to be used when compared to conventional CVD systems. Plasma enhancement is particularly useful for etching processes.

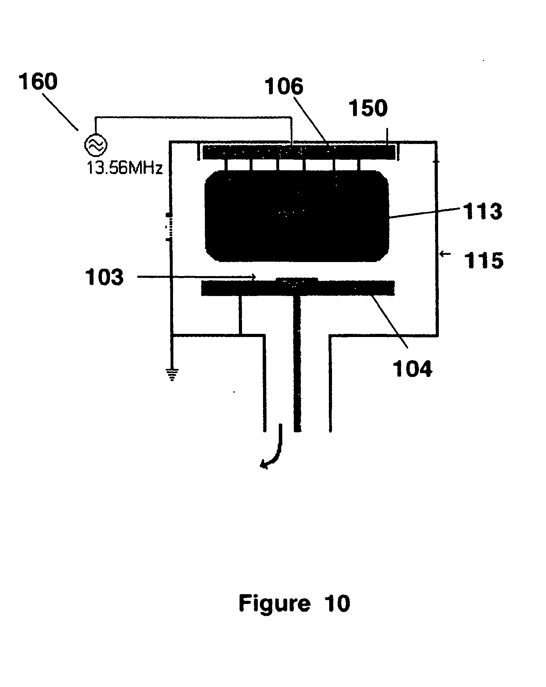

The plasma can be generated in situ within the reaction chamber using a parallel plate (PP) system or generated remotely from reaction chamber and/or substrate and then transported into the reaction chamber. A standard PP system is illustrated in Figure 10: a first plate 104 is used as a platform upon which the wafer substrate 103 is mounted and a second plate 150 is located in a parallel plane above the first plate 104. Both plates are located within a single chamber 115 and process gas mixtures are injected into this chamber 115 through an array of holes 106 in the upper second plate 150 in an assembly called a showerhead. Typically, the second plate 150 is then driven with a radio frequency (RF) current source 160 and plasma 113 is generated, using the injected gas mixtures, in the space between the two plates. The showerhead holes 106 are as narrow as can be practically manufactured to limit intense parasitic plasmas forming inside the holes. The formation of any plasma within the gas mixture inlets would produce an intense local plasma, which perturbs the uniformity of processing and can degrade the gas injection apparatus. Each hole normally takes the form of a small tube, with a length to diameter ratio of at least 5:1.

With contemporary developments in the field of PECVD and plasma etching, the use of high-density (HD) plasmas is becoming increasingly viable. High-density plasma CVD (HDPCVD) or etching systems are typically those in which the generated ion or electron density is greater than 10¹¹ cm⁻³. This also raises the dissociation efficiency by an order of magnitude when compared to standard parallel plate systems. These enhanced plasma properties further increase the processing rate and/or quality of HDPCVD processes and offers potential advantages of lower hydrogen content films, high quality films at lower process temperatures, void-free gap filling of high aspect ratio features, and self- planarisation when compared with conventional PECVD.

A common implementation of HDPCVD utilises an inductively coupled plasma (ICP) source comprising a plasma generation chamber encircled by an inductively coupled coil. This coil is driven with a RF supply in order to generate an electric field within the plasma generation chamber, which in turn in creates and ignites a plasma cloud. A variety of RF frequencies can be used including low frequencies (below 55kHz), high frequencies (13.56 MHz) or microwave frequencies (where the coil is replaced with a microwave cavity) (2.45GHz). By locating the plasma source remotely to the processing chamber, ICP systems allow high-density plasma to be generated remotely without affecting the surface processes within the processing chamber.

Two or more gases or gas mixtures are typically injected into an ICP HDPCVD system: a first gas or gas mixture is injected into the ICP generation chamber and a second gas or gas mixture is injected into the substrate reaction chamber. The generated electric field accelerates the electrons of the first gas within the plasma generation chamber, which ionises individual gas molecules and allows for the transfer of kinetic energy within individual electron-gas molecule collisions. US Patent 5,792,272 provides an example of a HD ICP reactor as is known in the art.

There are, however, several problems with the use of HDPCVD. In typical CVD systems process uniformity has been achieved by controlling the flow dynamics of the chemical substances in order to generate a uniform species distribution across the reaction surface of the wafer substrate. In an HDPCVD system the distribution of gases inside the processing chamber is very difficult to control as the plasma interacts with the flow dynamics of any injected gas.

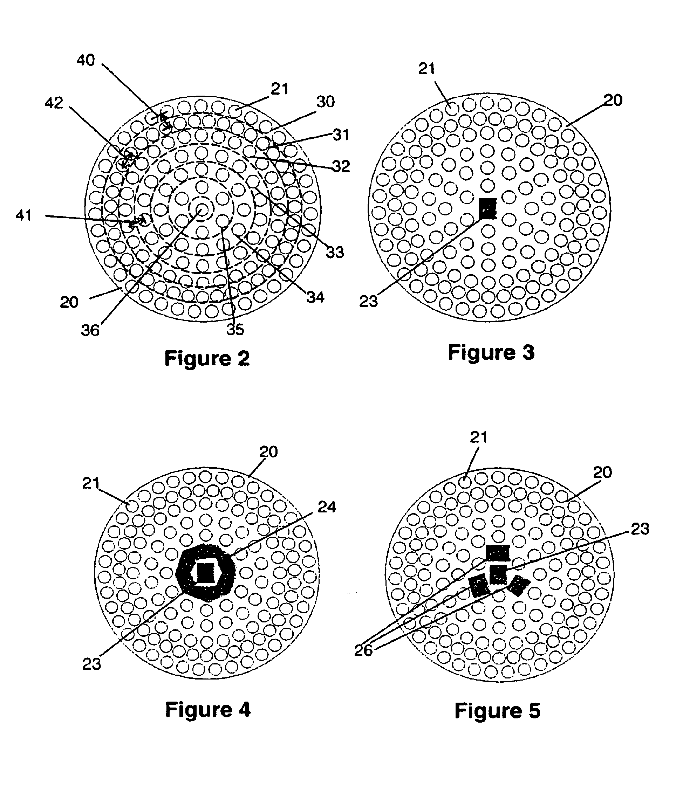

E. R. Keiter and M. J. Kushner discuss the problem of gas distribution in their paper "Radical and Electron Densities in a High Plasma Density-Chemical Vapour Deposition Reactor from a Three- Dimensional Simulation" published in the IEEE Transactions on Plasma Science, Vol. 27, No. 2, April 1999. Figure 2 of this paper clearly illustrates how the uniformity of deposition is strongly influenced by the gas flow patterns in the low pressure reaction space, and especially the flow pattern of the gases compound bearing the primary material for the film, typically silane SiH₄ for silicon containing films.

The uniformity of thin film deposition is an important performance parameter, with current deposition processes aiming for an error of around ± 3% across the diameter of the wafer substrate. This level of uniformity has been achieved in the prior art by either shaping the generated plasma using the associated RF induction coil or by using a particular arrangement of gas injectors.

EP-0870072-A1 teaches that a particular arrangement of gas injection nozzles in an annulus between the plasma source and the substrate can aid process uniformity. However, this increased uniformity is achieved through empirical adjustment of the nozzle geometry, which is cumbersome and requires complex modifications of the HDPCVD reactor apparatus. Additionally, by increasing the number of gas injection nozzles and altering the nozzle geometry complicated flow patterns can be set up within the processing chamber that can have an unpredicted effect on processing uniformity.

US Patents 5,800,621-A and 5,401,350 teach a method of adjusting the uniformity of an ICP source by configuring the arrangement of the RF induction coils. However, these methods require complicated modelling of the electric field parameters within the plasma source chamber and also typically have higher power demands and require more complicated electronic control.

US2006/0027166-A1 provides a substrate processing apparatus vacuum reactor that is internally divided into an upper part and a lower part that are separated from each other by an electrically conductive partitioning plate grounded. The upper part of the vacuum reactor is a plasma discharge space in which an rf electrode is arranged, and the lower part of the vacuum reactor is a substrate process space in which a substrate support mechanism is disposed. The partitioning plate has a plurality of through-holes that are provided to pass vertically through it, and has an internal space that is isolated from the plasma discharge space and communicates with the substrate process space. Each of the plurality of through-holes provided on the partitioning plate has a vertical length of between 5 mm and 30 mm, a bore diameter of between 5 mm and 30 mm and an aspect ratio of above 1 and below 2.

Another problem that arises with the use of all CVD processes is that chemicals applied to the wafer substrate typically further coat most of the processing chamber as well. The ability to clean the chamber in situ by a plasma process is thus important for PECVD and HDPCVD systems. As many prior art techniques for improving the uniformity also complicate the processing apparatus they increase the difficulty of cleaning the chamber in situ and the ability to repair or replace components affected in this way.

WO2006/000846-A1 describes a system for low-energy plasma-enhanced chemical vapour deposition comprising plasma source, deposition chamber and gas distribution system for semiconductor epitaxy on substrates up to 300 mm in size. The system allows for fast switching from high to low deposition rates, and film thickness control at the monolayer level. It incorporates chamber self-cleaning and the provisions for selective epitaxial growth. The system contains a broad-area plasma source which can be used also in other applications, such as low-energy ion implantation and plasma treatment of surfaces.

Therefore, a flexible method of controlling the uniformity of a process in an ICP HDPCVD system is desired. Preferably this solution should not significantly alter the construction of such systems and allow for simply cleaning and maintenance.

According to a first aspect of the present invention there is provided a surface processing apparatus for use in the surface processing of a substrate, the surface processing apparatus comprising a plasma source; a processing chamber in which a substrate is mounted in use, the processing chamber being operatively connected to the plasma source; and a transmission plate for the transmission of plasma in use between the plasma source and processing chamber, the transmission plate comprising a plurality of circular apertures wherein the physical form of the plurality of apertures and/or the distribution of the plurality of apertures is adapted to provide a predetermined processing pattern upon the surface of the substrate, and wherein the surface processing apparatus is characterised by the ratio of aperture diameter to transmission plate thickness being greater than 3:1.

The prior art teaches away from the use of a transmission plate because it is well known that excited and ionised plasma species are quickly quenched by contact with solid surfaces. Thus any technologies developed for use in altering generic gas flow are unsuitable for use in situations involving a plasma source and a connected processing chamber, due to the very different properties of the plasma species. Furthermore, whereas PECVD showerhead systems are designed to suppress plasma passing through the showerhead at all costs, the transmission plate is designed to allow active species to pass through the plate without significant quenching. By varying the fraction of plasma species that pass through different parts of the plate, a simple and effective means of optimising the uniformity of surface processing is provided.

By controlling the features of a transmission plate mounted between a plasma source and a processing chamber, the present invention allows the careful control of the processing upon the surface of the substrate. Typically, the transmission plate will be designed so that the physical form and/or distribution of the one or more apertures is such that a uniform processing rate is provided across the surface of the substrate. Such a plate is simple to remove and replace if different processing patterns are required or if the transmission plate needs to be cleaned and replaced. This is in contrast to the use of predetermined nozzle geometry or RF coil configurations, wherein the method of providing uniformity is intrinsically bound with the complete HDPCVD apparatus. With the present invention, a transmission plate can also be changed for use with different plasma species.

The ratio of aperture diameter to transmission plate thickness being greater than 3:1 allows a transmission plate to be used without destroying the active species making up the plasma. Typically, the transmission plate will be circular in form in correspondence with a substantially cylindrical plasma source and processing chamber. In these cases the plasma source is typically axially aligned with the processing chamber, which is mounted below the plasma source.

In some embodiments the plurality of apertures are distributed in one or more concentric aperture rings upon the transmission plate, the centre(s) of the one or more concentric aperture rings being that of the transmission plate. In these cases either the angular spacing of the plurality of apertures within each concentric aperture ring or the radial spacing between each pair of concentric aperture rings is adapted to provide a predetermined processing pattern upon the surface of the substrate.

Preferably, the plasma source generates an inductively coupled plasma and comprises a plasma chamber and an RF driven inductively coupled coil. Common drive parameters for the RF source are a frequency of 13.56 MHz and a power of 1 to 3 kW.

Typically, the apparatus uses two gas or gas mixture supplies: a first gas or gas mixture supply to the plasma source and a second gas or gas mixture supply to the processing chamber. Typical surface processing of the substrate comprises deposition or removal of material on or from the surface of the substrate. In some embodiments the physical form of the one or more apertures and/or the distribution of the one or more apertures is adapted to provide a substantially uniform deposition or material removal rate across a width of the substrate.

To prevent the thermal degradation of the transmission plate, and to limit particles flaking from the transmission plate through thermal cycling, the thermal conductivity of the plate is typically greater than 100W m-1 K-1 and the plate is thermally connected to an external chamber via a low thermal resistance path. The transmission plate can comprise either a metal or metal alloy plate. Alternatively a lower thermal conductivity material can be used with a lower thermal expansion coefficient, which can operate at higher temperatures, such as alumina ceramic. Where the transmission plate is to be used with chlorine-containing gas mixtures for etching, then alumina is preferred. It is also possible to use anodised aluminium or metal coated with a material more inert to the reactive plasma, such as plasma-sprayed alumina, to combine the beneficial effects of improved lateral heat conduction with inertness to the plasma.

According to a comparative example there is provided a method for the fabrication of a transmission plate for use in the surface processing of a substrate mounted within a processing chamber, the transmission plate being mounted in use between a plasma source and the processing chamber and comprising one or more apertures to allow the transmission of plasma from the plasma source to the processing chamber, the method comprising the steps of:
a) measuring the processing rate of a surface process on the substrate with respect to the radius of the substrate, r, using the plasma source and the processing chamber without a transmission plate;
b) fitting a process rate function d(r) to the measured process rate;
c) calculating a plasma transmission function T(r) as a function of a radius from the centre of the transmission plate, such that d(r) x T(r) is a constant;
d) defining an aperture design for the physical form of the one or more apertures and/or the distribution of the one or more apertures such that a measured plasma transmission function for the transmission plate provides a best fit to the plasma transmission function T(r); and
e) fabricating a transmission plate using the aperture design defined in step d).

By following this comparative example method, new transmission plates can be quickly and easily generated in response to new or different processing conditions.
According to a third aspect of the present invention there is provided a method of operating the apparatus as previously defined, the method comprising:
a) injecting a first gas or gas mixture into the plasma source on one side of the transmission plate;
b) injecting a second gas or gas mixture into the processing chamber of the other side of the transmission plate;
c) adjusting the gas flow ratio of the two injected gases in response to a measured processing rate.

Both gas mixtures can contain noble gases and both gas supplies may inject the same noble gas. This method further increases uniformity and the transmission plate limits the movement of undesired reactive gas species into the plasma source.

In order that the invention may be better understood, some embodiments of the invention will now be described with reference to the accompanying drawings in which:
Figure 1 illustrates a surface processing apparatus according to the present invention;
Figure 2 illustrates a first possible transmission plate aperture configuration in accordance with the present invention;
Figure 3 illustrates a second transmission plate aperture configuration in accordance with the present invention;
Figure 4 illustrates a third transmission plate aperture configuration in accordance with the present invention;
Figure 5 illustrates a fourth transmission plate aperture configuration in accordance with the present invention;
Figure 6 is a graph illustrating the effect of transmission plate aperture configuration on deposition rate;
Figure 7 is an illustration of a 3D model of a transmission plate according to the present invention;
Figure 8 is a second illustration of a 3D model of a transmission plate for use in SiOₓ deposition according to the present invention;
Figure 9 is a graph illustrating the effect of deposition thickness when using the transmission plate as shown in Figure 8;
Figure 10 illustrates a prior art parallel plate PECVD system;
Figure 11 is a graph illustrating the effect of changing the radius-to-thickness aspect ratio on transmission fraction;
Figure 12 is a graph illustrating the fit between an actual and ideal plasma transparency measure, the transparency being measured across the radius of a transmission plate; and
Figure 13 is a graph illustrating the effect of injecting argon gas above a transmission plate on deposition uniformity.

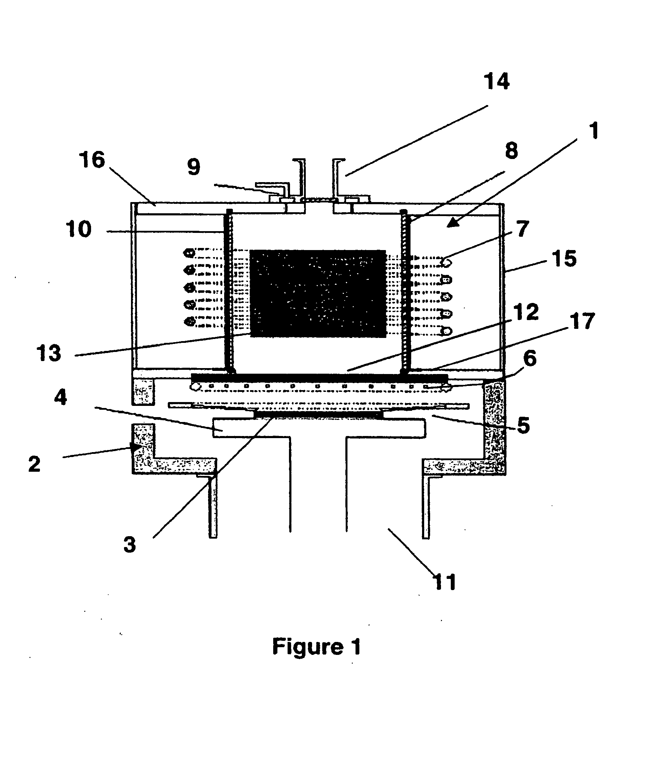

Figure 1 is a schematic illustration of a high-density plasma chemical vapour deposition (HDPCVD) system. The system consists of two main components: a plasma source 1 and a processing chamber 2. The plasma source comprises a plasma chamber 8 constructed from a dielectric cylindrical tube with a vertical axis surrounded by an electrostatic shield 10. Typically, quartz or alumina is used as the dielectric. At the top of the cylindrical tube 8 is a set of gas inlets 9, which have an axially symmetric distribution and are used to inject a first gas or gas mixture into the plasma chamber used in the plasma generation. Beneficially, this first gas mixture includes a noble gas such as argon. This gas or gas mixture is ionised and excited within the plasma source 1, then transports to the processing chamber 2 by a combination of flow and diffusion.

Surrounding this plasma chamber 8 is a water-cooled radio frequency (RF) coil antenna 7 that forms an inductively coupled coil for use in generating the plasma within the plasma chamber 8. The RF coil 7 is connected to a 13.56 MHz, 3 kW RF generator via a matching unit (not shown). Effectively, the current passing through the RF coil 7 generates an RF magnetic flux along the axis of the plasma chamber 8 and this magnetic flux further induces an RF electric field inside the plasma chamber 8. The induced electric field accelerates electrons within the injected gas cloud producing high-density plasma within the plasma chamber. By controlling the inductively coupled RF coil 7, an operator can control the dissociation of the plasma and the density of the incident ions in the plasma chamber 8. The most intense plasma is represented in Figure 1 by shaded region 13.

An inspection port 14 may be provided to observe the substrate surface by laser interferometry, provided the transmission plate has a suitably aligned hole. The top plate 16, side cover 15 and plasma source base plate 17 form an enclosure to contain RF radiation from the RF coil 7

Below the plasma source 1 is the processing chamber 2, which is axially aligned with the plasma chamber 8. The processing chamber 2 typically comprises a substrate table 4 made from a 205mm diameter cooled or heated lower electrode with helium assisted heat transfer. This table can be electrically grounded, or powered by a separate RF supply to control the ion impact energy at the substrate surface. A wafer substrate 3 is placed upon this substrate table 4 and can be further held in place using a modular clamping mechanism 5. The processing chamber 2 is typically kept at low pressure or within a vacuum by evacuation using a turbomolecular pump backed by a mechanical pump, via a pumping port 11 mounted beneath the substrate table 4. In this example, the pumping port 11 is a 200mm diameter high conductance pumping port. A ring of gas nozzles is provided in an annulus 6 at the top of the processing chamber 2, through which a gas or gas mixture is injected. In processes to deposit silicon compounds, the silicon-bearing gas such as silane is included in this gas mixture. Beneficially, a noble gas such as argon forms part of this mixture.

In use plasma 13 is generated within the plasma source 1 by providing the appropriate RF current to the ICP coil. In prior art systems, the plasma source 1 is directly connected to the processing chamber 2 and ion impact energy on the wafer substrate 3 is controlled by applying an RF bias to the substrate table 4. However, as is seen in the Keiter and Kushner paper discussed within the introduction, these prior art systems generate a non-uniform processing rate upon the wafer substrate 3.

Thus to provide uniformity, a transmission plate is mounted between the plasma source 1 and the processing chamber 2 and the plasma 13 is driven through the transmission plate 12, which modifies the electron distribution in the plasma cloud. In the present invention, the interruption of the plasma flow by the transmission plate alters the configuration of the flow.

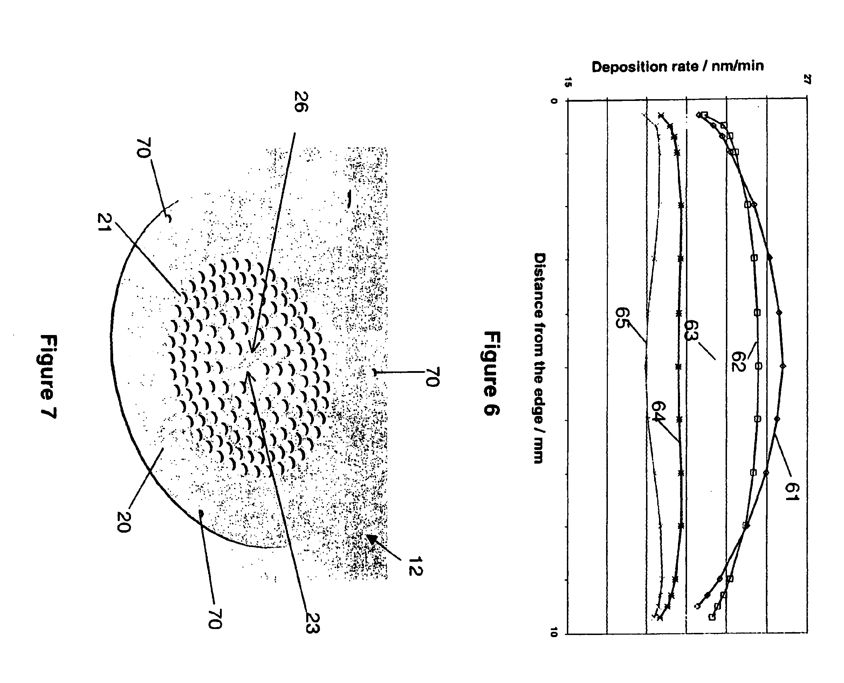

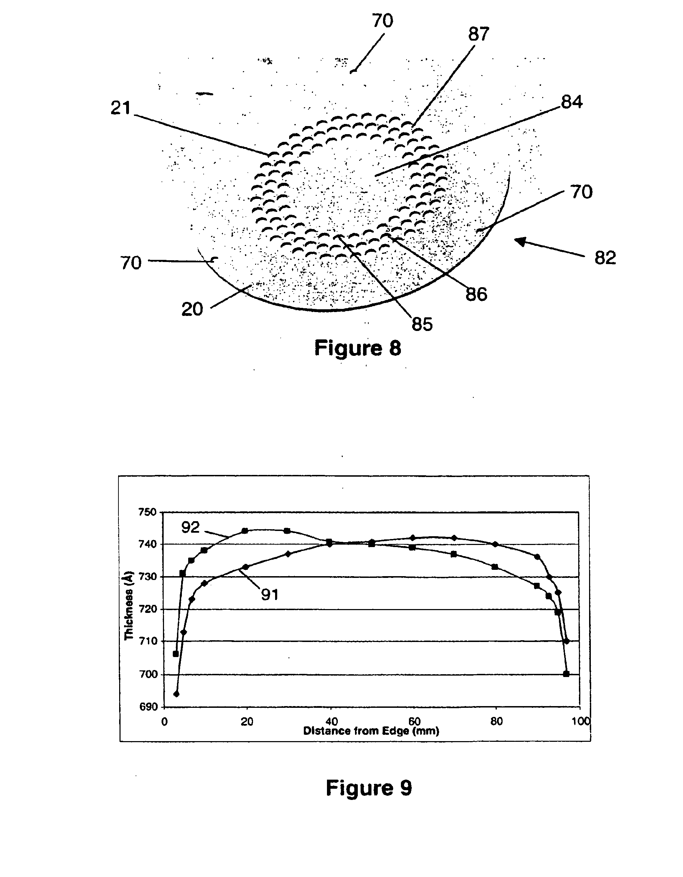

A comparative example method for generating the form and/or the arrangement of the apertures on the transmission plate will now be described in relation to the apparatus of Figure 1. First, a set surface process is selected and the apparatus of Figure 1 is set up accordingly but with the transmission plate 12 removed from the assembly. A test wafer substrate 3 is then placed on the substrate table 4 and a plasma is generated in the plasma source 1. This plasma is then used to deposit material upon the wafer without a transmission plate being present and the resultant wafer substrate 3 is then analysed. Using a test wafer substrate 3 the deposition rate for the HDPCVD process can be measured without the beneficial effects of the transmission plate 12. From this data a graph of deposition rate against wafer radius can be plotted in a similar manner to Figures 6 and 9. Once the experimental data has been plotted a deposition rate function d(r) can be fitted to the data so that a deposit rate can be calculated at any radius r. Any known data fitting techniques can be used including but not limited to least mean square error methods applied to cubic spline or polynomic curves.

After the deposition rate function d(r) has been fitted then a transmission function T(r) for the transmission plate is calculated to generate a plasma transmission function through the transmission plate as a function of transmission plate radius r. Both these functions assume that the transmission plate and the substrate wafer are axially aligned. The transmission function T(r) is calculated so that d(r) x T(r) = 1, i.e. the transmission function is calculated to be the inverse of the deposition rate function. Once a required transmission function T(r) has been calculated then a set of apertures can be generated or calculated to provide an actual plasma transmission distribution that best fits the transmission function T(r). This can either be done experimentally or theoretically, using standard plasma flow models and equations. For example, if the operating conditions are known then the velocity of a plasma as it moves towards the substrate table can be calculated to provide a plasma flux parameter in relation to the plasma flow. It can then be assumed that the transmission function T(r) is proportional to the plasma flux. By standard calculations the amount of aperture area per annular area of the transmission plate can be calculated and thus an aperture shape fitted to best match these area requirements.

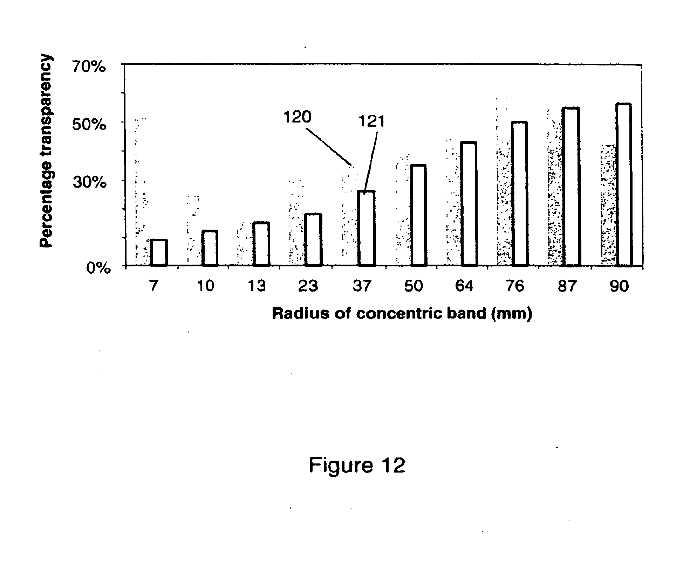

An example of the function fitting described in the above comparative example is illustrated in Figure 12. A transmission plate divided into 10 equal-width concentric bands is used as a starting point for the analysis of the required plasma transparency, a measure of plasma transmission, at a variety of radial positions. The ideal plasma transparency for each concentric band is shown in unfilled bars 121 and is derived from the deposition rate on a wafer substrate in the absence of a transmission plate. A design based on a series of simple rings of equal diameter holes, as illustrated in Figure 2and located across the 10 concentric bands, is then developed and the plasma transparency is calculated using equations known in the art. The design with a calculated plasma transparency that best fits the ideal transparency is then chosen. The transparency of the chosen design is shown in shaded bars 120 and provides a good fit to the ideal transparency required for a uniform surface process. There is only a lack of fit at the centre due to the required binary choice of inserting or omitting a single central hole.

Transmission plate variables that can be changed include, but are not limited to, the number of apertures per unit area, the shape of the aperture, the diameter of each aperture if circular apertures are used, the major and minor axes of each aperture if elliptical apertures are used, or any combination of the above. The number of apertures per unit area can further be defined using a concentric ring arrangement as illustrated in Figures 2 to 5, wherein the aperture density is dependent on the radial spacing of the concentric rings 30-35 and the concentric spacing of a set of circular apertures 21.

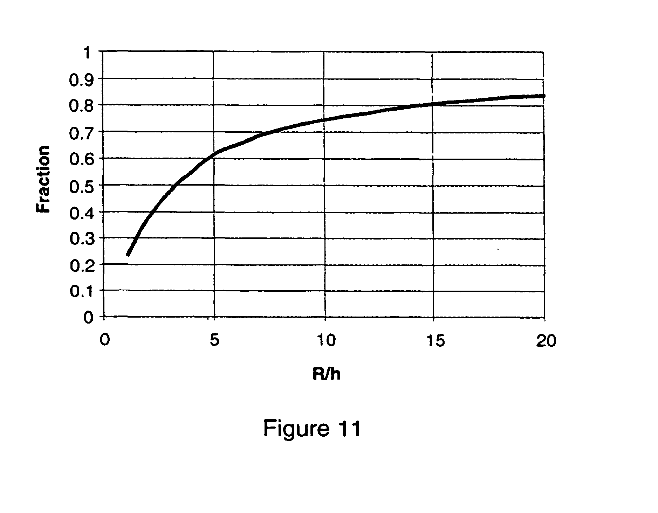

The development of an aperture design from a transmission function will generally involve constraints on aperture form. For example, if circular apertures are used the diameter of such apertures should be greater than the thickness of the transmission plate in order to ensure the efficiency of plasma flow through the transmission plate. Through experimental tests and modelling it has been found that an aperture diameter to plate thickness ratio of at least 3:1 provides a required transmission rate and prevents the destruction and recombination of active plasma species. The fraction of gas particles transmitted through a single circular hole of radius R in a plate of thickness h without contacting the wall has been calculated, and is shown in Figure 11. This calculation assumes that the mean free path is long compared to the hole dimensions. Figure shows that at least 50% of the species are transmitted, without a potentially quenching encounter with the wall, if the aspect ratio of the hole (radius: thickness) is at least 3:1, and at least 30% if the aspect ratio is 1.5:1 If non-circular apertures are used with associated width and length parameters instead of a diameter parameter a similar aperture width to plate thickness and/or aperture length to plate thickness ratio should be obeyed.

Examples of possible transmission plate configurations designed using this comparative example method are illustrated in Figures 2 to 5. Each transmission plate comprises a circular disc 20 in which there are a plurality of circular apertures 21 that allow the passage of plasma from the plasma source 1 to the processing chamber 2. By removing certain apertures 23, 24,and 26, highlighted by the dark shading in Figures 3 to 5, within the design process described above the resultant processing rate can be altered from that achieved with no transmission plate 12 present.

Figure 2 illustrates a basic aperture distribution comprising a central circular aperture 36 and six concentric aperture rings of increasing radii: first, outer concentric aperture ring 30 comprising 39 uniformly spaced circular apertures 21; second concentric aperture ring 31 also comprising 39 uniformly spaced circular apertures 21; third concentric aperture ring 32 comprising 28 uniformly spaced circular apertures 21; fourth concentric aperture ring 33 comprising 18 uniformly spaced circular apertures 21; fifth concentric aperture ring 34 comprising 12 uniformly spaced circular apertures 21; sixth concentric aperture ring 35 comprising 6 uniformly spaced circular apertures 21; and a central aperture 36. This pattern was derived using the method of transmission plate design described previously, with the further constraints of maximum transmission near the edge of the plate, a constant hole diameter of 10mm , and an adequate amount of metal remaining for lateral heat conduction and mechanical stability.

The first three concentric aperture rings 30, 31, 32 have a first uniform radial spacing 40, i.e. the distance from the centre of the circular apertures in the first outer concentric ring 30 to the centre of the circular apertures in the second concentric ring 31 is equal to the distance from the centre of the circular apertures in the second concentric ring 31 to the centre of the circular apertures in the third concentric ring 32. The inner concentric aperture rings 33, 34, 35 and the central aperture 36 have a second uniform radial spacing 41, which is greater than the first uniform radial spacing 40. The angular spacing 42 of the circular apertures in the outer three concentric aperture rings 30,31,32 varies with the second concentric aperture ring 31 having the highest aperture density per concentric ring. The inner concentric aperture rings 33, 34, 35 also have a varied angular spacing, with the minimum angular spacing being greater than the largest angular spacing of the outer three concentric aperture rings 30,31,32, and the angular spacing of the circular apertures increasing as the radius of the concentric aperture rings decreases.

Typically, the circular disc 20 is manufactured from aluminium alloy no. 6082 with a thickness of between 3 to 5 millimetres. To allow a suitable transmission rate, the diameter of the circular apertures 21 is greater than the thickness of the plate, typically for the illustrated transmission plates the ratio of aperture diameter to plate thickness is greater than 3:1. Hence, using the aluminium alloy above, the diameter of the circular apertures is between 9 and 15 mm, with the diameter of all apertures preferably greater than 9mm. However, an aperture diameter greater than 5mm will begin to demonstrate favourable transmission characteristics.

The effect of each transmission plate configuration illustrated in Figures 2 to 5 when used, with the apparatus of Figure 1, in the deposition of SiNₓ is illustrated in the graph shown in Figure 6. Line 61 illustrates how the deposition rate varies across the diameter of a 100mm wide wafer when a transmission plate 12 is absent from the apparatus. It is clearly visible that the absence of a transmission plate, as is found in the prior art, causes more material to be deposited in the centre of the wafer than at the edges. This then generates a non-uniform deposition pattern that can have negative consequences for downstream semiconductor and integrated circuit processing.

The use of a transmission plate as illustrated in Figure 2 improves the deposition rate profile across the wafer substrate, as illustrated by line 62 in Figure 6. The differing radial and angular spacing of the six concentric aperture rings mean that a greater amount of plasma can be transmitted through the outer three concentric aperture rings 30,31,32 than through the inner concentric aperture rings 33 to 35. By varying these parameters the plasma transmission factor per concentric ring area can be altered, which in turn will alter the deposition rate within corresponding concentric areas of the wafer substrate 3, assuming the wafer substrate 3 is axially aligned with the transmission plate 12. For example, as the concentric aperture density is greatest within the second concentric aperture ring 31, the plasma flux per concentric unit area, assuming a uniform plasma density and velocity perpendicular to the transmission plate 12, would also be a maximum. In real world use, the plasma density will vary in the plasma chamber 8 across the diameter of the transmission plate 12 and thus the differing aperture densities, created by the arrangement of the circular apertures 21, help generate a more uniform plasma density on the processing chamber 2 side of the plate. However, the transmission plate 12 illustrated in Figure 2 still generates some non-uniformity in deposition rate across the wafer substrate 3, and can be optimised further by iterating the design method, either experimentally or by further application of function fitting.

When the distribution of circular apertures 21 within the circular disc 20 of the transmission plate 12 is altered by removing the central aperture 23, as conceptually illustrated in Figure 3, then the peak deposition rate at the centre of the substrate wafer is reduced as illustrated by line 63. This is because, as the centre aperture 23 is no longer present in the transmission plate 12, plasma present near the centre of the plasma chamber 8 can no longer be perpendicularly transmitted into the processing chamber 2, thus generating a dearth of plasma near the centre of the processing chamber 2 and reducing the rate of chemical reactions at the centre of wafer substrate 3 below the transmission plate.

By further altering the distribution of circular apertures 21, for example by selecting which apertures should remain in the circular disc 20 and which should be excluded, the deposition rate across the wafer can be further modified. The aperture distribution shown in Figure 4 excludes the centre aperture 23 and removes the apertures of concentric aperture ring 35, conceptually illustrated by the shaded region 24. The resultant deposition rate profile with this configuration is further smoothed and is illustrated by line 65 in Figure 6. However, this pattern is still non-optimal as it now overly reduces the deposition rate in the centre of the wafer substrate 3, producing a 'm' shape deposition rate profile. An optimal deposition rate pattern is then provided by the transmission plate of Figure 5, which provides a substantially uniform deposition rate across the surface of the wafer as illustrated by line 64. In this configuration half of the circular apertures in the concentric aperture ring 35 remain and only the central aperture 23 and the shaded apertures 26 are removed. Experimental tests have further shown that a thickness uniformity of ± 1.50% (with 7mm edge exclusions) can be achieved in SiNₓ depositions. All the transmission plates in these tests used a plate thickness of 3mm and 10mm diameter holes.

As well as or instead of selecting certain apertures to include or exclude from the transmission plate 12, the diameter of certain apertures could also be modified. For example, if the circular apertures 21 are arranged in a series of concentric circles, similar to the concentric aperture ring 24, the diameter of each set of apertures in each concentric ring could reduce as the radius of each concentric ring reduces. This would then have a similar effect to the distribution shown in Figure 4 and Figure 5, wherein the rate of aperture diameter change across the radius of the plate would alter the deposition rate across the substrate wafer 3. Alternatively, a similar design based on a series of concentric rings could use elliptically shaped apertures. The major axis of each aperture can be decremented as the radius of each concentric circle decreases resulting in a pattern with wide or long ellipses in the outer concentric circles and near circular ellipses in the more central concentric circles. This again will produce a modified deposition rate which can help provide a more uniform deposition.

While the above distributions and arrangements have been described in relation to the deposition of material on a wafer substrate 3, it is equally possible that the apparatus can be used in the etching or removal of material from a wafer substrate. In these cases, as is known in the art, the activated plasma 13 provides a means to activate and dissociate chemical precursors, which react to remove material upon the surface of the wafer substrate 3.

A three dimensional model of the arrangement of Figure 5 is shown in Figure 7. In use the transmission plate 12 is mounted at 3 points 70 near the edge of the plate to the upper surface or base plate 17 of an external chamber 15 of the plasma source 1. The mountings are constructed to provide a low thermal resistance path in order to retain the transmission plate 12 within 20°C of the base plate 17 temperature. This was demonstrated with a temperature measurement at the centre of the plate while running a 3kW plasma in the source. The plate temperature never exceeded 70 C. Aluminium alloy no. 6082 has a high level of thermal conductivity to conduct heat away from the areas of the transmission plate in contact with the plasma 13, and the plate is typically thermally coupled to a section of the external chamber made from a material of similar thermal conductivity to further dissipate the generated heat. By minimising the temperature variations of the transmission plate 12 more material can be deposited upon the wafer substrate 3 without particles flaking from the transmission plate 12. Also by controlling the temperature of the transmission plate the negative interaction between the transmission plate and the active plasma can be reduced. Other metals or metal alloys can be used in place of the aluminium alloy, although it is recommended that such a metal or metal alloy has a thermal conductivity above 100 W m⁻¹ K⁻¹. Alternatively, the transmission plate 12 can be constructed from alumina sheet or another ceramic. An alumina transmission plate experiences a larger temperature rise than an equivalent aluminium transmission plate, because the thermal conductivity of the alumina is about one tenth of the thermal conductivity of the aluminium. However, the thermal expansion coefficient of the alumina is about one third that of aluminium and thus the thermal expansion coefficient of the alumina is better matched to the insulating layers most commonly deposited, so thermal cycling does not produce severe flaking of deposited materials.

As the transmission plate 12 is only connected to the external chamber by three connecting points 70, the transmission plate 12 can be easily installed or removed for a variety of operations. For example, new distributions can be applied or plates can be replaced if they begin to show degradation. To clean the transmission plate 12 in situ when depositing SiOₓ or SiNₓ films, a fluorine-containing plasma can be used, which will remove any deposits that have built up upon the plate.

As discussed previously, the transmission plate 12 may need to be changed when using different processing techniques or different chemical depositions. For example the transmission plate illustrated in Figure 7 is designed for use with SiNₓ deposition, however, when using SiOₓ deposition, less plasma activation is required to initiate deposition. Thus Figure 8 illustrates a SiOₓ transmission plate 82 for use in SiOₓ deposition. The SiOₓ transmission plate 82 comprises three concentric rings 85, 86, 87 of circular apertures 21 with no apertures being present in a central circular section 84 of the plate. The resultant north-south 91 and west-east 92 deposition levels across the substrate wafer when using this plate are shown in Figure 9. When using the transmission plate illustrated in Figure 8, a uniformity of ± 1.43% (with 7mm edge exclusions) can be generated across the 100mm wafer substrate 3. This then halves the uniformity variation obtained using a non-modified transmission plate, as shown in Figure 2, which is typically ± 3.5 %. Without a transmission plate the non-uniformity is even greater.

In empirical observations a total deposition thickness on the substrate of at least 5 microns and up to 20 microns has been demonstrated when using the transmission plate 12 without the film flaking from the transmission plate 12.

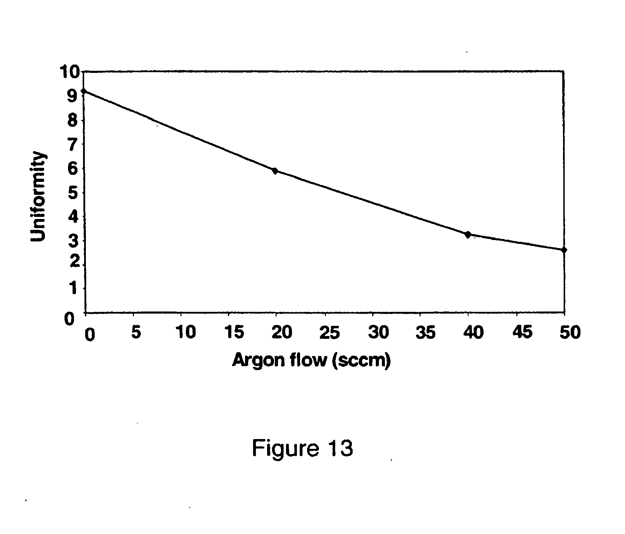

The presence of a transmission plate also makes it possible to tailor the steps of the surface process by choosing where to inject the different process gases. It is known that gases such as silanes must not be injected into the high-density plasma, i.e. into the plasma chamber 1, as these gases dissociate readily producing material that will adhere to the next surface they contact. The transmission plate 12 helps to limit the intrusion of such gases into the HDP region, keeping the plasma source region cleaner. Further, the injection of a noble gas above the plate will stream ions and excited species towards the substrate, while injection below the plate will serve to modify the diffusion of other species without adding so much extra ion bombardment. The noble gas injected above the transmission plate may also be the same noble gas injected with the gas mixture below the transmission plate. An example of the effect of this process is shown in Figure 13. This Figure demonstrates the change in the uniformity of SiO₂ deposition with the injection of argon into the plasma source 1. Uniformity is measured as the difference between the maximum and minimum deposition rate, and this measure decreases as the flow of argon gas into the plasma source increases.

In summary, the present invention has been described in relation to a number of embodiments and provides numerous advantages over the prior art including:
- the transmission plate 12 is easily demountable for changing to new transmission distributions;
- the transmission plate 12 can be cleaned in situ by a fluorine-containing plasma when depositing SiOx or SiNx films;
- the temperature of the transmission plate 12 can be controlled simply by making a good thermal connection to an external chamber at the transmission plate 12 mounting points.
- a total deposition thickness of at least 5 microns and up to 20 microns has been demonstrated using the current invention without the film flaking from the transmission plate 12; and
- the transmission plate 12 can be much simpler and economical compared to the complex gas nozzle and RF coil designs of prior art.

## Claims

1. A surface processing apparatus for use in the surface processing of a substrate, the surface processing apparatus comprising:
a plasma source (1);
a processing chamber (2) in which a substrate is mounted in use, the processing chamber (2) being operatively connected to the plasma source (1); and
a transmission plate (12) for the transmission of plasma in use between the plasma source (1) and processing chamber (2), the transmission plate (12) comprising a plurality of circular apertures (21) wherein the physical form of the plurality of apertures (21) and/or the distribution of the plurality of apertures (21) is adapted to provide a predetermined processing pattern upon the surface of the substrate, and wherein the surface processing apparatus is **characterised by** the ratio of aperture diameter to transmission plate thickness being greater than 3:1.

2. The surface processing apparatus of claim 1, wherein the diameter of each circular aperture (21) is greater than 5mm.

3. The surface processing apparatus of claims 1 or 2, wherein the diameter of each circular aperture (21) is greater than 9mm.

4. The surface processing apparatus of any of the preceding claims, wherein the transmission plate (12) is circular in form.

5. The surface processing apparatus of claim 4, wherein the plurality of apertures (21) are distributed in one or more concentric aperture rings (30) upon the transmission plate (12), the centre(s) of the one or more concentric aperture rings (30) being that of the transmission plate (12).

6. The surface processing apparatus of claim 5, wherein the concentric spacing of the plurality of apertures (21) within each concentric aperture ring (30) is adapted to provide a predetermined processing pattern upon the surface of the substrate.

7. The surface processing apparatus of claim 5 or claim 6, wherein a plurality of concentric aperture rings (30) are arranged upon the transmission plate (12) and the radial spacing between each pair of concentric aperture rings (30) is adapted to provide a predetermined processing pattern upon the surface of the substrate.

8. The surface processing apparatus of any of the preceding claims, wherein the plasma source (1) is an inductively coupled plasma.

9. The surface processing apparatus of claim 8, wherein the plasma source (1) comprises a plasma chamber (8) and an inductively coupled coil (7).

10. The surface processing apparatus of claim 9, wherein the inductively coupled coil (7) is connected to a radio frequency (RF) source.

11. The surface processing apparatus of claim 10, wherein the RF source supplies an RF current at 13.56MHz.

12. The surface processing apparatus of any of the preceding claims, further comprising a first gas supply to the plasma source (1) and a second gas supply to the processing chamber (2).

13. The surface processing apparatus of any of the preceding claims, wherein the surface processing of the substrate comprises the deposition of material on the surface of the substrate.

14. The surface processing apparatus of claim 13, wherein the physical form of the one or more apertures (21) and/or the distribution of the one or more apertures (21) is adapted to provide a substantially uniform deposition rate across a width of the substrate.

15. The surface processing apparatus of any of the preceding claims, wherein the surface processing of the substrate comprises the removal of material from the surface of the substrate.

16. The surface processing apparatus of claim 15, wherein the physical form of the one or more apertures (21) and/or the distribution of the one or more apertures (21) is adapted to provide a substantially uniform material removal rate across a width of the substrate.

17. The surface processing apparatus of any of the preceding claims, wherein the thermal conductivity of the transmission plate (12) is greater than 100 W m⁻¹ K⁻¹.

18. The surface processing apparatus of any of the preceding claims, wherein the transmission plate (12) is thermally connected to the processing chamber (2) via a low thermal resistance path.

19. The surface processing apparatus of any of the preceding claims, wherein the transmission plate (12) comprises a metal or metal alloy plate.

20. The surface processing apparatus of claim 19, wherein the transmission plate (12) comprises a metal or metal alloy plate coated with a layer resistant to attack by the plasma.

21. The surface processing apparatus of any of claims 1 to 17, wherein the transmission plate (12) comprises a ceramic plate.

22. The surface processing apparatus of claim 21, wherein the transmission plate (12) comprises an alumina plate.

23. The surface processing apparatus of any of claims 9 to 11, wherein the plasma chamber (8) and the processing chamber (2) comprise substantially cylindrical chambers.

24. The surface processing apparatus of claim 23, wherein the plasma chamber (8) and processing chamber (2) are axially aligned.

25. The surface processing apparatus of any of the preceding claims, wherein the plasma source (1) is mounted above the processing chamber (2).

26. A method of operating the apparatus defined in claim 1, the method comprising:
a) injecting a first gas or gas mixture into the plasma source (1) on one side of the transmission plate (12);
b) injecting a second gas or gas mixture into the processing chamber (2) of the other side of the transmission plate (12);
c) adjusting the gas flow ratio of the two injected gases in response to a measured processing rate.

27. The method of claim 26, wherein the first and second mixtures gases include noble gases.

28. The method of claim 27, wherein the first and second gases are the same noble gas.

29. The method of any of claims 26 to 28, wherein the temperature of the transmission plate (12) is kept within 20 degrees Celsius of the temperature of an external chamber.

## Patentansprüche

1. Eine Vorrichtung zur Oberflächenbearbeitung zur Verwendung bei der Oberflächenbearbeitung eines Substrats, wobei die Vorrichtung zur Oberflächenbearbeitung aus Folgenden besteht:
einer Plasmaquelle (1);
einer Prozesskammer (2), in der ein Substrat in der Anwendung montiert ist, wobei die Prozesskammer (2) operativ mit der Plasmaquelle (1) verbunden ist; und
einer Übertragungsplatte (12) für die Übertragung von Plasma in der Anwendung zwischen der Plasmaquelle (1) und der Prozesskammer (2), wobei die Übertragungsplatte (12) eine Reihe von runden Öffnungen (21) aufweist, wobei die physikalische Form der Reihe von Öffnungen (21) und/oder die Verteilung der Reihe von Öffnungen (21) so adaptiert wurde, dass sie ein vorbestimmtes Prozessmuster auf der Oberfläche des Substrats liefern, und wobei die Vorrichtung zur Oberflächenbearbeitung **dadurch gekennzeichnet ist, dass** das Verhältnis von Öffnungsdurchmesser zu Übertragungsplattendicke größer als 3:1 ist.

2. Die Vorrichtung zur Oberflächenbearbeitung entsprechend Anspruch 1, wobei der Durchmesser jeder runden Öffnung (21) größer als 5 mm ist.

3. Die Vorrichtung zur Oberflächenbearbeitung entsprechend Anspruch 1 oder 2, wobei der Durchmesser jeder runden Öffnung (21) größer als 9 mm ist.

4. Die Vorrichtung zur Oberflächenbearbeitung entsprechend einem der vorhergehenden Ansprüche, wobei die Übertragungsplatte (12) runde Form hat.

5. Die Vorrichtung zur Oberflächenbearbeitung entsprechend Anspruch 4, wobei die Reihe von Öffnungen (21) in einem oder mehreren konzentrischen Öffnungsringen (30) auf der Übertragungsplatte (12) verteilt ist, wobei das/die Zentrum/Zentren des einen oder der mehreren konzentrischen Öffnungsringen (30) das/die der Übertragungsplatte (12) ist/sind.

6. Die Vorrichtung zur Oberflächenbearbeitung entsprechend Anspruch 5, wobei die konzentrische Verteilung der Reihe von Öffnungen (21) in jedem konzentrischen Öffnungsring (30) so adaptiert ist, dass sie ein vorbestimmtes Prozessmuster auf der Oberfläche des Substrats liefert.

7. Die Vorrichtung zur Oberflächenbearbeitung entsprechend Anspruch 5 oder 6, wobei eine Reihe von konzentrischen Öffnungsringen (30) auf der Übertragungsplatte (12) angeordnet ist und der radiale Abstand zwischen jedem Paar an konzentrischen Öffnungsringen (30) so adaptiert ist, dass sie ein vorbestimmtes Prozessmuster auf der Oberfläche des Substrats liefert.

8. Die Vorrichtung zur Oberflächenbearbeitung entsprechend einem der vorhergehenden Ansprüche, wobei die Plasmaquelle (1) ein induktiv gekoppeltes Plasma ist.

9. Die Vorrichtung zur Oberflächenbearbeitung entsprechend Anspruch 8, wobei die Plasmaquelle (1) eine Plasmakammer (8) und eine induktiv gekoppelte Spule (7) umfasst.

10. Die Vorrichtung zur Oberflächenbearbeitung entsprechend Anspruch 9, wobei die induktiv gekoppelte Spule (7) an eine Radiofrequenz-(RF)-Quelle angeschlossen ist.

11. Die Vorrichtung zur Oberflächenbearbeitung entsprechend Anspruch 10, wobei die RF-Quelle einen RF-Strom von 13,56 MHz liefert.

12. Die Vorrichtung zur Oberflächenbearbeitung entsprechend einem der vorhergehenden Ansprüche, zu der weiterhin eine erste Gasversorgung zur Plasmaquelle (1) und eine zweite Gasversorgung zur Prozesskammer (2) gehört.

13. Die Vorrichtung zur Oberflächenbearbeitung entsprechend einem der vorhergehenden Ansprüche, wobei es sich bei der Oberflächenbearbeitung des Substrats um die Abscheidung von Material auf der Oberfläche des Substrats handelt.

14. Die Vorrichtung zur Oberflächenbearbeitung entsprechend Anspruch 13, wobei die physikalische Form der einen oder mehreren Öffnungen (21) und/oder die Verteilung der einen oder mehreren Öffnungen (21) so adaptiert ist, dass sie eine wesentlich gleichmäßige Abscheidungsrate über eine Breite des Substrats liefert.

15. Die Vorrichtung zur Oberflächenbearbeitung entsprechend einem der vorhergehenden Ansprüche, wobei es sich bei der Oberflächenbearbeitung des Substrats um das Abtragen von Material von der Oberfläche des Substrats handelt.

16. Die Vorrichtung zur Oberflächenbearbeitung entsprechend Anspruch 15, wobei die physikalische Form der einen oder mehreren Öffnungen (21) und/oder die Verteilung der einen oder mehreren Öffnungen (21) so adaptiert ist, dass sie eine wesentlich gleichmäßige Abtragungsrate über eine Breite des Substrats liefert.

17. Die Vorrichtung zur Oberflächenbearbeitung entsprechend einem der vorhergehenden Ansprüche, wobei die thermale Leitfähigkeit der Übertragungsplatte (12) größer als 100 W m⁻¹K⁻¹ ist.

18. Die Vorrichtung zur Oberflächenbearbeitung entsprechend einem der vorhergehenden Ansprüche, wobei die Übertragungsplatte (12) über einen Weg mit geringem thermischem Widerstand thermisch an die Prozesskammer (2) angeschlossen ist.

19. Die Vorrichtung zur Oberflächenbearbeitung entsprechend einem der vorhergehenden Ansprüche, wobei die Übertragungsplatte (12) eine Metall- oder Metalllegierungsplatte ist.

20. Die Vorrichtung zur Oberflächenbearbeitung entsprechend Anspruch 19, wobei die Übertragungsplatte (12) eine Metall-oder Metalllegierungsplatte ist, die mit einer Schicht beschichtet ist, die gegen Plasmaangriff resistent ist.

21. Die Vorrichtung zur Oberflächenbearbeitung entsprechend einem der Ansprüche 1 bis 17, wobei die Übertragungsplatte (12) eine Keramikplatte ist.

22. Die Vorrichtung zur Oberflächenbearbeitung entsprechend Anspruch 21, wobei die Übertragungsplatte (12) eine Aluminiumplatte ist.

23. Die Vorrichtung zur Oberflächenbearbeitung entsprechend einem der Ansprüche 9 bis 11, wobei die Plasmakammer (8) und die Prozesskammer (2) wesentlich zylindrische Kammern sind.

24. Die Vorrichtung zur Oberflächenbearbeitung entsprechend Anspruch 23, wobei die Plasmakammer (8) und die Prozesskammer (2) axial aufeinander ausgerichtet sind.

25. Die Vorrichtung zur Oberflächenbearbeitung entsprechend einem der vorhergehenden Ansprüche, wobei die Plasmaquelle (1) oberhalb der Prozesskammer (2) montiert ist.

26. Ein Verfahren zum Betrieb der in Anspruch 1 definierten Vorrichtung, wobei das Verfahren aus Folgenden besteht:
a) Injektion eines ersten Gases oder eines Gasgemischs in die Plasmaquelle (1) auf einer Seite der Übertragungsplatte (12);
b) Injektion eines zweiten Gases oder eines Gasgemischs in die Prozesskammer (2) auf der anderen Seite der Übertragungsplatte (12);
c) Einstellen des Gasstromverhältnisses der zwei injizierten Gase in Reaktion auf eine gemessene Prozessrate.

27. Das Verfahren entsprechend Anspruch 26, wobei zum ersten und zweiten Gasgemisch Edelgase gehören.

28. Das Verfahren entsprechend Anspruch 27, wobei das erste und das zweite Gas das selbe Edelgas sind.

29. Das Verfahren entsprechend einem der Ansprüche 26 bis 28, wobei die Temperatur der Übertragungsplatte (12) innerhalb von 20°C der Temperatur einer externen Kammer gehalten wird.

## Revendications

1. Appareil de traitement de surface à des fins d'utilisation dans le traitement de surface d'un substrat, l'appareil de traitement de surface comportant :
une source de plasma (1) ;
une chambre de traitement (2) dans laquelle un substrat est monté au cours de l'utilisation, la chambre de traitement (2) étant raccordée de manière fonctionnelle à la source de plasma (1) ; et
une plaque de transmission (12) destinée à des fins de transmission du plasma au cours de l'utilisation entre la source de plasma (1) et la chambre de traitement (2), la plaque de transmission (12) comportant une pluralité d'ouvertures circulaires (21) dans lequel la forme physique de la pluralité d'ouvertures (21) et/ou la distribution de la pluralité d'ouvertures (21) est adaptée à des fins de mise en oeuvre d'un déroulement de traitement prédéterminé sur la surface du substrat, et dans lequel l'appareil de traitement de surface est **caractérisé par** le rapport entre le diamètre des ouvertures et l'épaisseur de la plaque de transmission qui est supérieur à 3:1.

2. Appareil de traitement de surface selon la revendication 1, dans lequel le diamètre de chaque ouverture circulaire (21) est supérieur à 5 mm.

3. Appareil de traitement de surface selon la revendication 1 ou la revendication 2, dans lequel le diamètre de chaque ouverture circulaire (21) est supérieur à 9 mm.

4. Appareil de traitement de surface selon l'une quelconque des revendications précédentes, dans lequel la plaque de transmission (12) est de forme circulaire.

5. Appareil de traitement de surface selon la revendication 4, dans lequel les ouvertures de la pluralité d'ouvertures (21) sont distribuées sur un ou plusieurs anneaux d'ouverture concentriques (30) sur la plaque de transmission (12), le (ou les) centre(s) desdits un ou plusieurs anneaux d'ouverture concentriques (30) étant celui de la plaque de transmission (12).

6. Appareil de traitement de surface selon la revendication 5, dans lequel l'espace concentrique de la pluralité d'ouvertures (21) à l'intérieur de chaque anneau d'ouverture concentrique (30) est adapté à des fins de mise en oeuvre d'un déroulement de traitement prédéterminé sur la surface du substrat.

7. Appareil de traitement de surface selon la revendication 5 ou la revendication 6, dans lequel des anneaux d'une pluralité d'anneaux d'ouverture concentriques (30) sont arrangés sur la plaque de transmission (12) et l'espace radial entre chaque paire d'anneaux d'ouverture concentriques (30) est adapté à des fins de mise en oeuvre d'un déroulement de traitement prédéterminé sur la surface du substrat.

8. Appareil de traitement de surface selon l'une quelconque des revendications précédentes, dans lequel la source de plasma (1) est un plasma à couplage inductif.

9. Appareil de traitement de surface selon la revendication 8, dans lequel la source de plasma (1) comporte une chambre à plasma (8) et une bobine à couplage inductif (7).

10. Appareil de traitement de surface selon la revendication 9, dans lequel la bobine à couplage inductif (7) est raccordée à une source de radiofréquence (RF).

11. Appareil de traitement de surface selon la revendication 10, dans lequel la source RF fournit un courant RF à 13,56 MHz.

12. Appareil de traitement de surface selon l'une quelconque des revendications précédentes, comportant par ailleurs une première alimentation en gaz à destination de la source de plasma (1) et une seconde alimentation en gaz à destination de la chambre de traitement (2).

13. Appareil de traitement de surface selon l'une quelconque des revendications précédentes, dans lequel le traitement de surface du substrat comporte le dépôt de matériau sur la surface du substrat.

14. Appareil de traitement de surface selon la revendication 13, dans lequel la forme physique desdites une ou plusieurs ouvertures (21) et/ou la distribution desdites une ou plusieurs ouvertures (21) est adaptée à des fins de mise en oeuvre d'un taux de dépôt sensiblement uniforme en travers d'une largeur du substrat.

15. Appareil de traitement de surface selon l'une quelconque des revendications précédentes, dans lequel le traitement de surface du substrat comporte le retrait de matériau en provenance de la surface du substrat.

16. Appareil de traitement de surface selon la revendication 15, dans lequel la forme physique desdites une ou plusieurs ouvertures (21) et/ou la distribution desdites une ou plusieurs ouvertures (21) est adaptée à des fins de mise en oeuvre d'un taux de retrait sensiblement uniforme en travers d'une largeur du substrat.

17. Appareil de traitement de surface selon l'une quelconque des revendications précédentes, dans lequel la conductivité thermique de la plaque de transmission (12) est supérieure à 100 W m⁻¹ K⁻¹.

18. Appareil de traitement de surface selon l'une quelconque des revendications précédentes, dans lequel la plaque de transmission (12) est raccordée de manière thermique à la chambre de traitement (2) par le biais d'un chemin à faible résistance thermique.

19. Appareil de traitement de surface selon l'une quelconque des revendications précédentes, dans lequel la plaque de transmission (12) est constituée d'une plaque d'alliage métallique ou de métal.

20. Appareil de traitement de surface selon la revendication 19, dans lequel la plaque de transmission (12) est constituée d'une plaque d'alliage métallique ou de métal revêtue au moyen d'une couche résistante contre toute attaque par le plasma.

21. Appareil de traitement de surface selon l'une quelconque des revendications 1 à 17, dans lequel la plaque de transmission (12) est constituée d'une plaque de céramique.

22. Appareil de traitement de surface selon la revendication 21, dans lequel la plaque de transmission (12) est constituée d'une plaque d'alumine.

23. Appareil de traitement de surface selon l'une quelconque des revendications 9 à 11, dans lequel la chambre à plasma (8) et la chambre de traitement (2) sont constituées de chambres sensiblement cylindriques.

24. Appareil de traitement de surface selon la revendication 23, dans lequel la chambre à plasma (8) et la chambre de traitement (2) sont alignées dans le sens axial.

25. Appareil de traitement de surface selon l'une quelconque des revendications précédentes, dans lequel la source de plasma (1) est montée au-dessus de la chambre de traitement (2).

26. Procédé de fonctionnement de l'appareil selon la revendication 1, le procédé comportant les étapes consistant à :
a) injecter un premier gaz ou mélange de gaz dans la source de plasma (1) d'un côté de la plaque de transmission (12) ;
b) injecter un second gaz ou mélange de gaz dans la chambre de traitement (2) de l'autre côté de la plaque de transmission (12) ;
c) ajuster la régulation de débit de gaz des deux gaz injectés en réponse à un débit de traitement mesuré.

27. Procédé selon la revendication 26, dans lequel les premier et second mélanges de gaz comprennent des gaz nobles.

28. Procédé selon la revendication 27, dans lequel les premier et second gaz sont les mêmes gaz nobles.

29. Procédé selon l'une quelconque des revendications 26 à 28, dans lequel la température de la plaque de transmission (12) est maintenue à plus ou moins 20 degrés Celsius de la température d'une chambre externe.
